(19) Europäisches Patentamt / European Patent Office / Office européen des brevets

(11) **EP 4 561 001 A1**

(12) **EUROPEAN PATENT APPLICATION**

(43) Date of publication:
   **28.05.2025 Bulletin 2025/22**

(21) Application number: **23211896.8**

(22) Date of filing: **24.11.2023**

(51) International Patent Classification (IPC):
   **H04L 27/36** (2006.01)    **H03F 3/24** (2006.01)
   **H03C 5/00** (2006.01)

(52) Cooperative Patent Classification (CPC):
   **H04L 27/361; H03C 5/00; H03F 3/19; H03F 3/245;**
   **H03G 3/3042; H03F 2200/451**

(84) Designated Contracting States:
   **AL AT BE BG CH CY CZ DE DK EE ES FI FR GB**
   **GR HR HU IE IS IT LI LT LU LV MC ME MK MT NL**
   **NO PL PT RO RS SE SI SK SM TR**
   Designated Extension States:
   **BA**
   Designated Validation States:
   **KH MA MD TN**

(71) Applicants:
   • **Imec VZW**
     **3001 Leuven (BE)**
   • **Vrije Universiteit Brussel**
     **1050 Brussel (BE)**

(72) Inventors:
   • **Nguyen, Johan**
     **1500 Halle (BE)**
   • **Wambacq, Pierre**
     **1702 Groot-Bijgaarden (BE)**
   • **Cooman, Adam**
     **1000 Brussel (BE)**

(74) Representative: **Körfer, Thomas**
   **Mitscherlich PartmbB**
   **Patent- und Rechtsanwälte**
   **Karlstraße 7**
   **80333 München (DE)**

(54) **DIGITAL POLAR TRANSMITTER, METHOD FOR IMPROVING A DIGITAL POLAR TRANSMITTER, AND CORRESPONDING COMPUTER PROGRAM**

(57)    A digital polar transmitter (10) with improved transmission behavior is provided. Said digital polar transmitter (10) comprises a first modulating unit (11a) with a first variable gain being controllable with the aid of a first phase-referred signal ($\alpha(t)$), a second modulating unit (11b) with a second variable gain being controllable with the aid of second phase-referred signal ($\beta(t)$), a third modulating unit (14), especially an amplitude modulating unit, with a third variable gain being controllable with the aid of an amplitude-referred signal ($\gamma(t)$), and an adding unit (12) for forming the sum of an output of the first modulating unit (11a) and an output of the second modulating unit (11b) and providing said sum at an adding unit output. In this context, the first phase-referred signal ($\alpha(t)$) and the second phase-referred signal ($\beta(t)$) are synchronized. In addition to this, the amplitude-referred signal ($\gamma(t)$) is synchronized with respect to the first phase-referred signal ($\alpha(t)$) and/or the second phase-referred signal ($\beta(t)$).

Fig. 1

EP 4 561 001 A1

## Description

## Technical Field

The invention relates to a digital polar transmitter with improved transmission behavior, a method for improving the transmission behavior of a digital polar transmitter, and a computer program with program code means to make at least a part or all of the steps of such a method.

## Background Art

Generally, in times of an increasing number of communication applications employing digital polar transmitters, there is a growing need of a digital polar transmitter with improved transmission behavior, a method for improving the transmission behavior of a digital polar transmitter, and a computer program with program code means to make at least a part or all of the steps of such a method in order to ensure correct functioning of such applications especially in the sense of allowing for synchronization of the corresponding amplitude and phase path of such a digital polar transmitter in a particularly accurate and efficient manner.

US 2002/0121892 A1 relates to a method and an apparatus to characterize a modulator without requiring access to modulator local oscillators. A periodic signal is input so that at least two tones are output, and the envelope of the filtered output is detected. The modulated output signal is generally differentially filtered before envelope detection. The measured amplitude and phase of the envelope of the differentially filtered modulator output frequencies, combined with the known filter characteristics, are used to deduce the amplitude and phase of the modulated output. The modulator input signal frequencies may be controlled to substantially limit the output to frequencies which differ from a reference frequency by odd multiples of a delta frequency, reducing intermodulation components. In this special case, the modulator output may be deduced from a squared envelope signal without a need for differential filtering. The deduced output, compared to the known input, characterizes the modulator at the input frequencies. Disadvantageously, such a characterization does not allow for synchronization of the corresponding amplitude and phase path of a digital polar transmitter in a particularly accurate and efficient manner.

## Summary

Accordingly, there is an object among others to provide a digital polar transmitter with improved transmission behavior, a method for improving the transmission behavior of a digital polar transmitter, and a computer program with program code means to make at least a part or all of the steps of such a method, wherein a particularly high accuracy of the synchronization of the corresponding amplitude and phase path of the digital polar transmitter and/or a particularly efficient corresponding operation are/is ensured.

This object is solved by the features of the first independent claim for a digital polar transmitter with improved transmission behavior, the features of the second independent claim for a method for improving the transmission behavior of a digital polar transmitter, and the features of the third independent claim for a computer program with program code means to make at least a part or all of the steps of such a method. The dependent claims contain further developments.

According to a first aspect of the present invention, a digital polar transmitter with improved transmission behavior is provided. Said digital polar transmitter comprises a first modulating unit, especially a first modulating unit, with a first variable gain being controllable with the aid of a first phase-referred signal, a second modulating unit, especially a second modulating unit, with a second variable gain being controllable with the aid of second phase-referred signal, a third modulating unit, especially an amplitude modulating unit, with a third variable gain being controllable with the aid of an amplitude-referred signal, and an adding unit for forming the sum of an output of the first modulating unit and an output of the second modulating unit and providing said sum at an adding unit output. In this context, the first phase-referred signal and the second phase-referred signal are synchronized. In addition to this, the amplitude-referred signal is synchronized with respect to the first phase-referred signal and/or the second phase-referred signal. Advantageously, a particularly high accuracy of the synchronization of the corresponding amplitude and phase path of the digital polar transmitter and/or a particularly efficient corresponding operation, especially due to a corresponding single-shot calibration, are/is ensured.

According to an implementation form of the first aspect of the present invention, the digital polar transmitter further comprises a driver unit for providing a driver unit output on the basis of the adding unit output. In this context, the third modulating unit is configured to amplify the driver unit output and to provide the correspondingly amplified driver unit output at a third modulating unit output. Advantageously, for instance, accuracy and/or efficiency can further be increased.

According to a further implementation form of the first aspect of the present invention, at least the first modulating unit and the second modulating unit are configured to form a phase shifting and/or modulating unit, preferably a cartesian-based phase shifting and/or modulating unit, comprising a corresponding phase path. In addition to this or as an alternative, at least the third modulating unit is configured to form a digital-to-analog converter, preferably a radio frequency digital-to-analog converter, comprising a corresponding amplitude path. Advantageously, for example, the phase path and the amplitude path can be synchronized in a particularly accurate and efficient manner. Further advantageously, especially with the aid of the cartesian-based phase shifting and/or modulating unit, full range excitation can efficiently be achieved.

It is noted that it might be particularly advantageous if at least the first modulating unit and the second modulating unit are configured to form a phase modulator during corresponding normal operation. In addition to this or as an alternative, it might be particularly advantageous if at least the first modulating unit and the second modulating unit are configured to form a cartesian modulator during corresponding calibration.

According to a further implementation form of the first aspect of the present invention, a delay between the phase path and the amplitude path is compensated preferably on the basis of a delay estimation. Advantageously, for instance, inaccuracies can efficiently be reduced.

According to a further implementation form of the first aspect of the present invention, the delay estimation is based on a first signal sequence and/or a second signal sequence extracted from an output signal of the digital polar transmitter preferably for the case that a multisine signal is applied to the digital polar transmitter. Advantageously, for example, no iterations are needed for delay estimation, thereby saving time, and thus further increasing efficiency.

According to a further implementation form of the first aspect of the present invention, the first signal sequence comprises or is a first part of the output signal of the digital polar transmitter, wherein in said first part, only the corresponding amplitude is modulating. In addition to this or as an alternative, the second signal sequence comprises or is a second part of the output signal of the digital polar transmitter, wherein in said second part only the corresponding phase is modulating. Advantageously, for instance, these are the slices in time where the corresponding spectrum looks clean.

According to a further implementation form of the first aspect of the present invention, the basis of the delay estimation is refined or substituted by a quotient signal obtained by dividing, preferably point-wise dividing, a first spectrum of the first signal sequence through a second spectrum of the second signal sequence. Advantageously, for example, the corresponding frequency bins of the one signal path are point-wise or bin-wise divided by the other.

According to a further implementation form of the first aspect of the present invention, the basis of the delay estimation is refined or substituted by the slope of the corresponding phase of the quotient signal. Advantageously, for instance, the slope of the corresponding phase corresponds to the time delay of the two paths.

According to a further implementation form of the first aspect of the present invention, a frequency response of the driver unit is equalized. Advantageously, for example, equalization can compensate for different frequency shaping on the phase samples compared to the amplitude samples.

According to a further implementation form of the first aspect of the present invention, the first modulating unit comprises or is a first variable-gain amplifier. In addition to this or as an alternative, the second modulating unit comprises or is a second variable-gain amplifier. Advantageously, for instance, complexity can be reduced, thereby increasing efficiency, which can analogously apply for the following implementation form of the first aspect of the present invention.

According to a further implementation form of the first aspect of the present invention, the third modulating unit comprises or is a third variable-gain amplifier.

According to a second aspect of the present invention, a method for improving the transmission behavior of a digital polar transmitter is provided. Said method comprises the steps of applying a multisine signal to the digital polar transmitter, extracting a first signal sequence and/or a second signal sequence from an output signal of the digital polar transmitter for a delay estimation, and compensating a delay between the corresponding phase path of a phase shifting and/or modulating unit, preferably a cartesian-based phase shifting and/or modulating unit, and the corresponding amplitude path of a digital-to-analog converter, preferably a radio frequency digital-to-analog converter, on the basis of said delay estimation.

Advantageously, a particularly high accuracy of the synchronization of the corresponding amplitude and phase path of the digital polar transmitter and/or a particularly efficient corresponding operation, especially due to a corresponding single-shot calibration, are/is ensured. Further advantageously, a corresponding optimum minimum point can reliably and/or always be found.

According to an implementation form of the second aspect of the present invention, the first signal sequence comprises or is a first part of the output signal of the digital polar transmitter, wherein in said first part, only the corresponding amplitude is modulating. In addition to this or as an alternative, the second signal sequence comprises or is a second part of the output signal of the digital polar transmitter, wherein in said second part only the corresponding phase is modulating. Advantageously, for instance, these are the slices in time where the corresponding spectrum looks clean.

According to a further implementation form of the second aspect of the present invention, the basis of the delay estimation is refined or substituted by a quotient signal obtained by dividing, preferably point-wise or bin-wise dividing, a first spectrum of the first signal sequence through a second spectrum of the second signal sequence. Advantageously, for example, the corresponding frequency bins of the one signal path are point-wise or bin-wise divided by the other.

According to a third aspect of the present invention, a computer program with program code means to make at least a part or all of the steps according to the second aspect of the present invention if the program is loaded on a computer or a digital signal processor or a digital polar transmitter, especially a control unit of the digital polar transmitter, is provided.

Advantageously, a particularly high accuracy and efficiency of the synchronization of the corresponding amplitude and phase path of the digital polar transmitter are ensured.

**Brief Description of the Drawings**

Exemplary embodiments of the invention are now further explained with respect to the drawings by way of example only, and not for limitation. In the drawings:

Fig. 1       shows a block diagram of an exemplary embodiment of the digital polar transmitter with improved transmission behavior;

Fig. 2A     shows a time domain representation of a signal measured at the output of the digital polar transmitter;

Fig. 2B     shows the corresponding spectrogram with respect to the time domain representation of Fig. 2A;

Fig. 3       illustrates relation between slope of phase and delay; and

Fig. 4       shows a flow chart of an exemplary embodiment of the method for improving the transmission behavior of a digital polar transmitter.

**Detailed Descriptions of Embodiments**

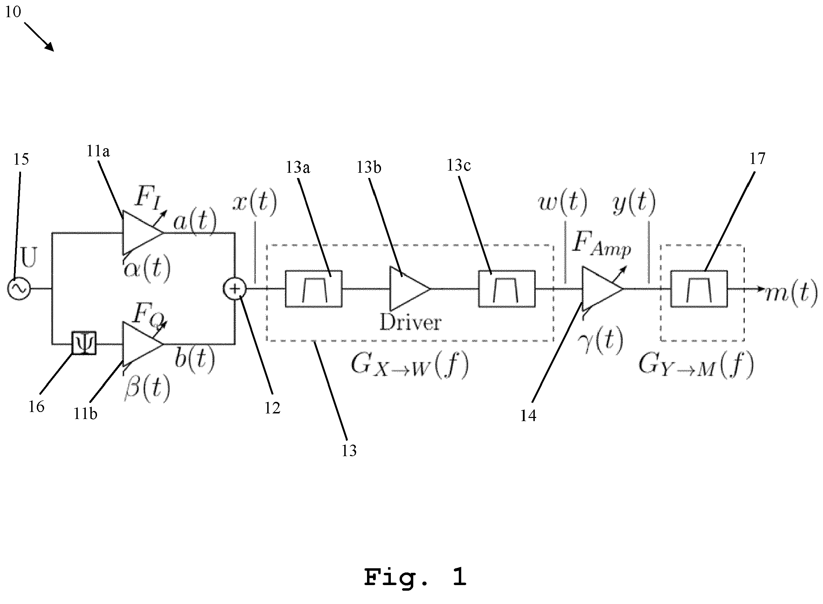

In accordance with Fig. 1, an exemplary embodiment of a digital polar transmitter 10 with improved transmission behavior comprises a first modulating unit 11a, especially a first phase modulating unit, with a first variable gain being controllable with the aid of a first phase-referred signal $\alpha(t)$, a second modulating unit 11b, especially a second phase modulating unit, with a second variable gain being controllable with the aid of second phase-referred signal $\beta(t)$, an adding unit 12 for forming the sum of an output of the first modulating unit 11a, exemplarily denoted as signal $a(t)$, and an output of the second modulating unit 11b, exemplarily denoted as signal $b(t)$, and providing said sum at an adding unit output, exemplarily denoted as signal $x(t)$, and a driver unit 13 for providing a driver unit output, exemplarily denoted as signal $w(t)$, on the basis of the adding unit output. In other words, the corresponding output of the adding unit 12 is exemplarily connected to the corresponding input of the driver unit 13. In this context, the first phase-referred signal $\alpha(t)$ and the second phase-referred signal $\beta(t)$ are synchronized. It is noted that it is particularly advantageous if the corresponding phase path is synched with the corresponding amplitude path.

As it can further be seen from Fig. 1, an input of the first modulating unit 11a is directly supplied by a signal generated by signal generating unit 15, whereas an input of the second modulating unit 11b is supplied by said signal generated by said signal generating unit 15 via a 90 degrees phase shifter 16 or a hybrid.

Furthermore, the digital polar transmitter 10 comprises a third modulating unit 14, especially an amplitude modulating unit, with a third variable gain being controllable with the aid of an amplitude-referred signal $\gamma(t)$. In this context, the third modulating unit 14 is configured to amplify the driver unit output, exemplarily the signal $w(t)$, and to provide the correspondingly amplified driver unit output at a third modulating unit output, exemplarily denoted as signal $y(t)$.

In addition to this, the amplitude-referred signal $\gamma(t)$ is synchronized with respect to the first phase-referred signal $\alpha(t)$ and/or the second phase-referred signal $\beta(t)$. It is noted that it might be particularly advantageous if the first phase-referred signal $\alpha(t)$, the second phase-referred signal $\beta(t)$, and the amplitude-referred signal $\gamma(t)$ are synchronized.

Moreover, at least the first modulating unit 11a and the second modulating unit 11b are exemplarily configured to form a phase shifting and/or modulating unit, especially a cartesian-based phase shifting and/or modulating unit, comprising a corresponding phase path, especially the above-mentioned corresponding phase path.

Additionally, at least the third modulating unit 14 is exemplarily configured to form a digital-to-analog converter, preferably a radio frequency digital-to-analog converter, comprising a corresponding amplitude path, especially the above-mentioned corresponding amplitude path.

In other words, the phase shifting and/or modulating unit exemplarily comprises a cartesian topology, comprising a hybrid with the first modulating unit 11a, exemplarily being a first variable-gain amplifier, and the second modulating unit 11b, exemplarily being a second variable-gain amplifier. Furthermore, the radio frequency digital-to-analog converter is given by the third modulating unit 14, exemplarily being a third variable-gain amplifier.

Advantageously, corresponding non-idealities that are calibrated is the delay between the phase samples $\alpha(t)$ and $\beta(t)$ on the one hand, and $\gamma(t)$ on the other hand. Further advantageously, the corresponding frequency response of the driver unit 13, exemplarily denoted as $G_{x \rightarrow w}(f)$, can be equalized. In this context, said frequency response can exemplarily be estimated by taking the ratio of the respective Fourier transforms, especially FFTs, of the above-mentioned signals $w(t)$ and $x(t)$.

It is further noted that a delay between the above-mentioned phase path and the above-mentioned amplitude path is exemplarily compensated on the basis of a delay estimation. In this context, the delay estimation is exemplarily based on a first signal sequence and/or a second signal sequence extracted from an output signal of the digital polar transmitter 10 for the case that a multisine signal is applied to the digital polar transmitter 10.

Accordingly, said multisine signal is used to measure the delay between said phase and amplitude path. Advantageously, the delay between amplitude and phase can be found in a single measurement without iteration.

With respect to said multisine signal, it is noted that such a multisine signal especially is a signal that is the sum of a sinusoid with a fixed period and all its harmonics. A general formula to calculate the time sequence is found in equation (1) below:

$$x(t) = \sum_{k=1}^{N} A_k \sin(k\omega t + \phi_k) \qquad . \qquad (1)$$

The amplitude $A_k$ of the frequency components is taken equal while the phase is often or preferably randomized. It is noted that it might be particularly advantageous if the multisine signal comprises the least Peak-to-Average-power ratio (PAPR). Advantageously, this makes the spectral purity of the measured data higher.

Again, with respect to the above-mentioned delay estimation, a multisine signal preferably with a small PAPR is generated especially in the context of said delay estimation. Said multisine signal is applied to the digital polar transmitter 10 such that a corresponding version for the amplitude path and the phase path is created. It might be particularly advantageous if the two correspondingly deduced signals are as big as possible such that the effect of quantization noise is reduced. Advantageously, the correspondingly full code range can be covered.

Furthermore, these two signals are exemplarily both repeated at least twice in order to get a full period where no overlap of the two paths occur. In front of one, a constant sequence can be added as long as the other signal modulates, behind the other a constant sequence can be added as long as the first modulates. This way, in the case without delay between the two paths, one signal path 'talks' or modulates, respectively, while the other is silent (constant programming code) or at constant maximum code, respectively, and vice versa. Moreover, this sequence is sent to the amplitude path and to the phase path and the output of the digital polar transmitter 10 is measured.

It is noted that the digital polar transmitter 10 may especially comprises a control unit configured to perform and/or support at least a part of the above-mentioned signal generation, preferably multisine signal generation, and/or at least a part of the signal measurement as described above and below.

It is further noted that the above-mentioned two signal will not be aligned while combining in the digital polar transmitter 10 because of the difference in delay. As a consequence, there will be a part where the two signals perform modulation at the same time.

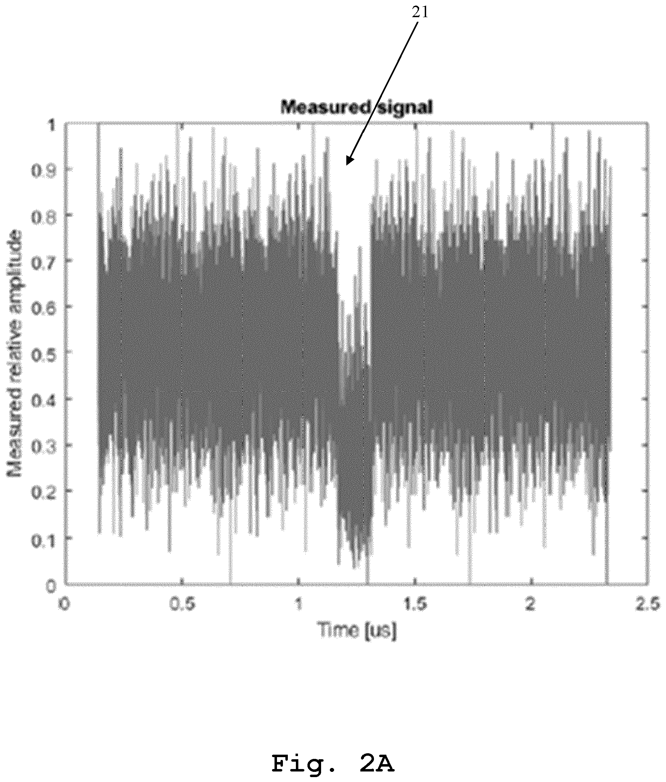

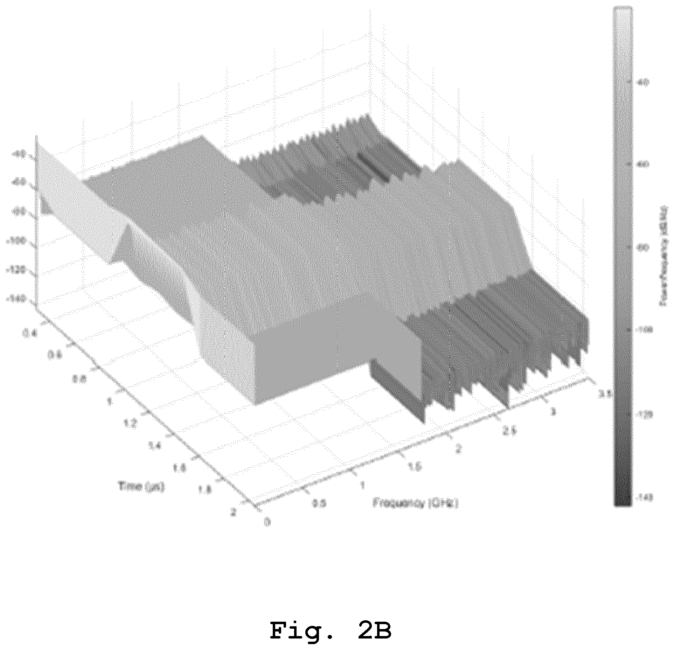

An exemplary time domain representation of the correspondingly measured signal can be seen in Fig. 2A, whereas the corresponding spectrogram of this measured signal is illustrated by Fig. 2B.

With respect to said Fig. 2A, it is noted that in a region 21, exemplarily a middle region, the corresponding signal looks different as both above-mentioned two signals modulate at the same time in that region 21.

With respect to said Fig. 2B, it is noted that the corresponding spectrum looks clean when only one path modulates while looks noisy when both modulate at the same time.

Furthermore, especially in the context of the above-mentioned delay estimation, a sequence where only the amplitude is modulating and a sequence where only the phase is modulating are extracted from the corresponding measurement.

Accordingly, the above-mentioned first signal sequence especially comprises or is a first part of the output signal of the digital polar transmitter 10, wherein in said first part, only the corresponding amplitude is modulating. Additionally or alternatively, the above-mentioned second signal sequence especially comprises or is a second part of the output signal of the digital polar transmitter 10, wherein in said second part only the corresponding phase is modulating. Advantageously, these are the slices in time where the corresponding spectrum looks clean.

It is noted that, especially in the context of delay estimation, a Fourier transform, exemplarily an FFT, can be applied on both time domain sequences to achieve the respective spectrum as denoted by equations (2) and (3) below:

$$A_{meas}(\omega) = \mathcal{F}(A_{meas}(t)) \qquad , \qquad (2)$$

$$\phi_{meas}(\omega) = \mathcal{F}(\phi_{meas}(t)) \qquad . \qquad (3)$$

Moreover, the corresponding frequency bins of the one signal path can be point-wise divided by the other as denoted by the following equation (4):

$$H(\omega) = A_{meas}(\omega)/\phi_{meas}(\omega) \qquad . \qquad\qquad (4)$$

Accordingly, the basis of the delay estimation can be refined or substituted by a quotient signal obtained by dividing, preferably point-wise dividing, a first spectrum of the first signal sequence through a second spectrum of the second signal sequence.

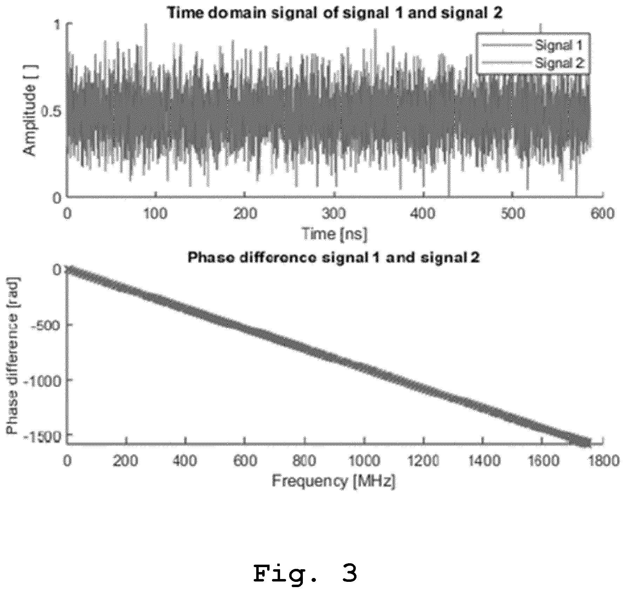

Furthermore, as additionally illustrated by Fig. 3, the slope of the phase of this resulting signal (see equation (5) below) corresponds to the time delay $\tau$ of the two paths (see equation (6) below).

$$\phi_{H(\omega)} = \arctan(\frac{Im(H(\omega))}{Re(H(\omega))}) \qquad , \qquad\qquad (5)$$

$$\tau = -\frac{\phi_{H(\omega)}}{\omega} \qquad . \qquad\qquad (6)$$

Accordingly, the basis of the delay estimation can be refined or substituted by the slope of the corresponding phase of the above-mentioned quotient signal. In accordance with equation (6) above, the slope of the phase especially gives back the delay between the two signal paths. The bigger the slope, the more delay there is between the two paths.

It is noted that the relative delay in the corresponding time window slices should be taken into account especially to get a accurate delay result. Furthermore, the transfer function of $H(\omega)$ can preferably be the corresponding equalization filter to compensate for the different frequency shaping on the phase samples compared to the amplitude samples. Multiplying the phase samples in the frequency domain with the inverse of $H(\omega)$ not only compensates for the delay but also equalizes these samples especially such that higher bandwidths are advantageously achieved.

Again, with respect to Fig. 1, for the sake of completeness and especially in the light of the above-mentioned cartesian topology, it is noted that the first modulating unit 11a is part of an I-path in the phase shifting and/or modulating unit or the cartesian-based phase shifting and/or modulating unit, respectively, whereas the second modulating unit 11b is part of a Q-path in the phase shifting and/or modulating unit or the cartesian-based phase shifting and/or modulating unit, respectively.

As it can further be seen from Fig. 1, with respect to the above-mentioned driver unit 13, it is noted that said driver unit 13 exemplarily comprises a first filter 13a, especially a first bandpass filter, an amplifier 13b, and a second filter or a matching network 13c, especially a second bandpass filter or a matching network with bandpass filter characteristic. Accordingly, the above-mentioned signal x(t) is filtered with the aid of the first filter 13a, then amplified with the aid of the amplifier 13b, and afterwards filtered with the aid of the second filter or processed in the sense of matching of impedances with the aid of the matching network 13c to form the above-mentioned signal w(t). With respect to said matching of impedances, it is noted that it might be particularly advantageous if the matching of impedances comprises or is matching of impedances of cascading power amplifier stages.

Furthermore, the above-mentioned signal y(t) is exemplarily filtered with the aid of a third filter or output matching network 17, especially a third bandpass filter or a matching network configured to match the corresponding impedances, to form a signal m(t). The corresponding frequency response of the third filter 17 is exemplarily denoted as $G_{Y \rightarrow M}(f)$.

Now, a major part of the explanations above is outlined in a nutshell in the following. Basically, it can be summarized that, especially at the beginning, a training sequence is applied to the digital polar transmitter 10.

Accordingly, the above-mentioned control unit of the digital polar transmitter 10 or an external device, exemplarily a transmission behavior improving device, can be configured to apply a training sequence to the digital polar transmitter.

Moreover, especially in the context of a first part of said training sequence, the Q-path in the phase shifting and/or modulating unit is modulated by two periods of the same multisine signal, while the amplitude path is at maximum code, and the I-path is fully off. It is noted that it might be particularly advantageous if the above-mentioned control unit of the digital polar transmitter 10 or the above-mentioned external device, exemplarily the above-mentioned transmission behavior improving device, respectively, is configured accordingly especially to achieve this.

Furthermore, especially in the context of a second part of the training sequence, the Q-path is at maximum code, while the amplitude path is modulated with two periods of the multisine signal. It is noted that it might be particularly advantageous if the above-mentioned control unit of the digital polar transmitter 10 or the above-mentioned external device, exemplarily the above-mentioned transmission behavior improving device, respectively, is configured accordingly especially to achieve this.

If there is a delay to be compensated, the correspondingly performed measurement comprises a part where both paths modulate and a part where none modulates. In this context, one slice is taken where only the amplitude path modulates, and one slice is taken where only the phase shifting and/or modulating unit modulates. It is noted that it might be particularly advantageous if the above-mentioned control unit of the digital polar transmitter 10 or the above-mentioned external device, exemplarily the above-mentioned transmission behavior improving device, respectively, is configured accordingly especially to achieve this.

Afterwards, from the respective Fourier transform, especially from the respective FFT, and the corresponding relative delay of the time slices, the corresponding delay and equalization filter can be calculated preferably for the corresponding phase shifting and/or modulating unit samples. It is noted that it might be particularly advantageous if the above-mentioned control unit of the digital polar transmitter 10 or the above-mentioned external device, exemplarily the above-mentioned transmission behavior improving device, respectively, is configured accordingly especially to achieve this.

Advantageously, with the aid of such an efficient one-shot measurement, the phase samples can be synchronized and equalized with the amplitude samples. A further advantage is that one multisine-based training sequence allows to characterize both the amplitude and phase signal path while one can only measure at one output.

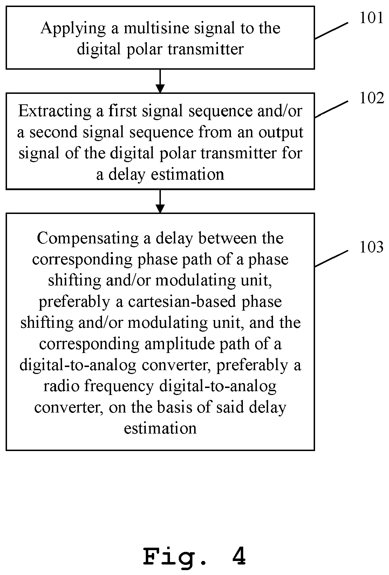

Finally, Fig. 4 shows a flow chart of an exemplary embodiment of the method for improving the transmission behavior of a digital polar transmitter such as the digital polar transmitter 10 according to Fig. 1.

In accordance with said Fig. 4, a first step 101 comprises applying a multisine signal to the digital polar transmitter.

Furthermore, a second step 102 comprises extracting a first signal sequence and/or a second signal sequence from an output signal of the digital polar transmitter for a delay estimation.

Moreover, a third step 103 comprises compensating a delay between the corresponding phase path of a phase shifting and/or modulating unit, preferably a cartesian-based phase shifting and/or modulating unit, and the corresponding amplitude path of a digital-to-analog converter, preferably a radio frequency digital-to-analog converter, on the basis of said delay estimation.

It is noted that it might be particularly advantageous if the first signal sequence comprises or is a first part of the output signal of the digital polar transmitter, wherein in said first part, only the corresponding amplitude is modulating.

Additionally or alternatively, the second signal sequence may comprise or be a second part of the output signal of the digital polar transmitter, wherein in said second part only the corresponding phase is modulating.

It is further noted that it might be particularly advantageous if the basis of the delay estimation is refined or substituted by a quotient signal obtained by dividing, preferably point-wise dividing, a first spectrum of the first signal sequence through a second spectrum of the second signal sequence.

While various embodiments of the present invention have been described above, it should be understood that they have been presented by way of example only, and not limitation. Numerous changes to the disclosed embodiments can be made in accordance with the disclosure herein without departing from the spirit or scope of the invention. Thus, the breadth and scope of the present invention should not be limited by any of the above-described embodiments. Rather, the scope of the invention should be defined in accordance with the following claims and their equivalents.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

**Claims**

1. A digital polar transmitter (10) with improved transmission behavior, comprising:

    a first modulating unit (11a), especially a first phase modulating unit, with a first variable gain being controllable with the aid of a first phase-referred signal ($\alpha(t)$),
    a second modulating unit (11b), especially a second phase modulating unit, with a second variable gain being controllable with the aid of second phase-referred signal ($\beta(t)$),
    a third modulating unit (14), especially an amplitude modulating unit, with a third variable gain being controllable with the aid of an amplitude-referred signal ($\gamma(t)$), and
    an adding unit (12) for forming the sum of an output of the first modulating unit (11a) and an output of the second modulating unit (11b) and providing said sum at an adding unit output,
    wherein the first phase-referred signal ($\alpha(t)$) and the second phase-referred signal ($\beta(t)$) are synchronized, and
    wherein the amplitude-referred signal ($\gamma(t)$) is synchronized with respect to the first phase-referred signal ($\alpha(t)$) and/or the second phase-referred signal ($\beta(t)$).

2. The digital polar transmitter (10) according to claim 1, wherein the digital polar transmitter (10) further comprises:

a driver unit (13) for providing a driver unit output on the basis of the adding unit output,
wherein the third modulating unit (14) is configured to amplify the driver unit output and to provide the correspondingly amplified driver unit output at a third modulating unit output.

3. The digital polar transmitter (10) according to claim 1 or 2,

wherein at least the first modulating unit (11a) and the second modulating unit (11b) are configured to form a phase shifting and/or modulating unit, preferably a cartesian-based phase shifting and/or modulating unit, comprising a corresponding phase path, and/or
wherein at least the third modulating unit (14) is configured to form a digital-to-analog converter, preferably a radio frequency digital-to-analog converter, comprising a corresponding amplitude path.

4. The digital polar transmitter (10) according to claim 3, wherein a delay between the phase path and the amplitude path is compensated preferably on the basis of a delay estimation.

5. The digital polar transmitter (10) according to claim 4, wherein the delay estimation is based on a first signal sequence and/or a second signal sequence extracted from an output signal of the digital polar transmitter (10) preferably for the case that a multisine signal is applied to the digital polar transmitter (10).

6. The digital polar transmitter (10) according to claim 5, wherein the first signal sequence comprises or is a first part of the output signal of the digital polar transmitter (10), wherein in said first part, only the corresponding amplitude is modulating, and/or
wherein the second signal sequence comprises or is a second part of the output signal of the digital polar transmitter (10), wherein in said second part only the corresponding phase is modulating.

7. The digital polar transmitter (10) according to claim 5 or 6,
wherein the basis of the delay estimation is refined or substituted by a quotient signal obtained by dividing, preferably point-wise dividing, a first spectrum of the first signal sequence through a second spectrum of the second signal sequence.

8. The digital polar transmitter (10) according to claim 7, wherein the basis of the delay estimation is refined or substituted by the slope of the corresponding phase of the quotient signal.

9. The digital polar transmitter (10) according to any of the claims 2 to 8,
wherein a frequency response of the driver unit (13) is equalized.

10. The digital polar transmitter (10) according to any of the claims 1 to 9,

wherein the first modulating unit (11a) comprises or is a first variable-gain amplifier, and/or
wherein the second modulating unit (11b) comprises or is a second variable-gain amplifier.

11. The digital polar transmitter (10) according to any of the claims 1 to 10,
wherein the third modulating unit (14) comprises or is a third variable-gain amplifier.

12. A method for improving the transmission behavior of a digital polar transmitter (10), said method comprising the steps of:

applying (101) a multisine signal to the digital polar transmitter (10),
extracting (102) a first signal sequence and/or a second signal sequence from an output signal of the digital polar transmitter (10) for a delay estimation, and
compensating (103) a delay between the corresponding phase path of a phase shifting and/or modulating unit, preferably a cartesian-based phase shifting and/or modulating unit, and the corresponding amplitude path of a digital-to-analog converter, preferably a radio frequency digital-to-analog converter, on the basis of said delay estimation.

13. The method according to claim 12,

wherein the first signal sequence comprises or is a first part of the output signal of the digital polar transmitter (10),

wherein in said first part, only the corresponding amplitude is modulating, and/or

wherein the second signal sequence comprises or is a second part of the output signal of the digital polar transmitter (10), wherein in said second part only the corresponding phase is modulating.

14. The method according to claim 12 or 13,

wherein the basis of the delay estimation is refined or substituted by a quotient signal obtained by dividing, preferably point-wise dividing, a first spectrum of the first signal sequence through a second spectrum of the second signal sequence.

15. A computer program with program code means to make at least a part or all of the steps according to claim 12 if the program is loaded on a computer or a digital signal processor or a digital polar transmitter (10), especially a control unit of the digital polar transmitter (10).

Fig. 1

EP 4 561 001 A1

Fig. 2A

Fig. 2B

Fig. 3

Applying a multisine signal to the
digital polar transmitter

101

Extracting a first signal sequence and/or
a second signal sequence from an output
signal of the digital polar transmitter for
a delay estimation

102

Compensating a delay between the
corresponding phase path of a phase
shifting and/or modulating unit,
preferably a cartesian-based phase
shifting and/or modulating unit, and the
corresponding amplitude path of a
digital-to-analog converter, preferably a
radio frequency digital-to-analog
converter, on the basis of said delay
estimation

103

Fig. 4

Europäisches
Patentamt

European
Patent Office

Office européen
des brevets

# EUROPEAN SEARCH REPORT

**Application Number**

EP 23 21 1896

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/088091 A1 (SHEN DAVID H [US] ET AL) 2 April 2009 (2009-04-02) * paragraph [0022] – paragraph [0052] * ----- | 1-15 | INV. H04L27/36 H03F3/24 H03C5/00 |

**TECHNICAL FIELDS SEARCHED (IPC)**

H04L
H03F
H03D
H03C

The present search report has been drawn up for all claims

| Place of search | Date of completion of the search | Examiner |
|---|---|---|
| The Hague | 17 April 2024 | Dupuis, Hervé |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 21 1896**

This annex lists the patent family members relating to the patent documents cited in the above-mentioned European search report.
The members are as contained in the European Patent Office EDP file on
The European Patent Office is in no way liable for these particulars which are merely given for the purpose of information.

**17-04-2024**

| Patent document cited in search report | Publication date | Patent family member(s) | | Publication date |
|---|---|---|---|---|
| US 2009088091 A1 | 02-04-2009 | TW | 200934142 A | 01-08-2009 |
| | | US | 2009088091 A1 | 02-04-2009 |
| | | WO | 2009043017 A1 | 02-04-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020121892 A1